# EUROPÄISCHE PATENTANMELDUNG

(11) **EP 0 802 422 A2**
(43) Veröffentlichungstag der Anmeldung: **22.10.1997**
(21) Anmeldenummer: 97201093.8
(22) Anmeldetag: 11.04.1997
(51) Int. Cl.: G01R 31/316

(54) **Messschaltung**

(30) Priorität: 20.04.1996 DE 19615745
(71) Anmelder: Philips Patentverwaltung GmbH, 22335 Hamburg (DE); Philips Electronics N.V., 5621 BA Eindhoven (NL)
(72) Erfinder: Reich, Joachim, Röntgenstra e 24, 22335 Hamburg (DE)
(74) Vertreter: von Laue, Hanns-Ulrich, Dipl.-Ing.

(57) **Zusammenfassung**

Für eine Meßschaltung für eine auf einem integrierten Schaltkreis vorgesehene Signalverarbeitungsschaltung (1) zur Verarbeitung wenigstens eines Bildsignals ist zur von äußeren Einflüssen möglichst unbeeinflußten Messung der Frequenzbandbreite der Signalverarbeitungsschaltung vorgesehen, daß der Signalverarbeitungsschaltung (1) Meßimpulse zugeführt werden, daß die Meßschaltung in Abhängigkeit der zeitlichen Verschiebung, die die Meßimpulse in der Signalverarbeitungsschaltung (1),erfahren, die Ladung einer in der Meßschaltung vorgesehenen Kapazität (10) verändert, daß die Meßschaltung die Meßkapazität (10) vor jedem Meßvorgang mittels eines elektronischen Schalters (8) kurzzeitig auf ein Bezugspotential schaltet und daß die Meßschaltung auf demselben integrierten Schaltkreis vorgesehen ist wie die Signalverarbeitungsschaltung (1) und nur während eines Meßvorganges aktiviert ist.

## Beschreibung

Die Erfindung betrifft eine Meßschaltung für eine auf einem integrierten Schaltkreis vorgesehene Signalverarbeitungsschaltung zur Verarbeitung wenigstens eines Bildsignals.

Ein wesentliches Qualitätskriterium für Signalverarbeitungsschaltungen, die Bildsignale verarbeiten, ist die Bandbreite der Signalverarbeitungsschaltung, d.h. diejenige Frequenzbandbreite, mit der die Signalverarbeitungsschaltung das Bildsignal verarbeiten kann. Eine zu geringe Bandbreite führt zu Signalverschleifungen des Bildsignals. Die Frequenzbandbreite derartiger Signalverarbeitungsschaltungen wird konventionell extern gemessen. D.h. es wird mittels eines speziellen Meßkopfes der auf dem integrierten Schälikrels vorgesehenen Signalverarbeitungsschaltung ein Bildsignal zugeführt, welches ausgangsseitig mittels desselben Meßkopfes abgetastet wird. Anhand der Signalverschleifungen des Bildsignals kann dann die Frequenzbandbreite, mit der die Signalverarbeitungsschaltung das Bildsignal verarbeitet, ermittelt werden. Ein großes Problem hierbei ist, daß die Kontakte zwischen dem Meßkopf und dem integrierten Schaltkreis unsicher sind, so daß Meßfehler entstehen. Ferner haben bereits die Zuführungen des Meßkopfes zu dem integrierten Schaltkreis und der Meßkopf selber eine so hohe Kapazität, daß diese bereits nennenswert die Bandbreite des zu messenden Signals begrenzen. Dies führt ebenfalls zu Meßfehlern.

Aus dem europäischen Patent 0 274 613 ist eine auf einem Chip integrierte Schaltung bekannt, welche eine Vorhersage der Eigenschaften der übrigen auf dem Chip vorgesehenen Signalverarbeitungsschaltungen gestatten soll. Diese Schaltung zur Vorhersage der Eigenschaften ist getrennt von der übrigen Signalverarbeitungsschaltung, deren Eigenschaften abzuschätzen sind, aufgebaut. Der Schaltungsanordnung zur Abschätzung der Eigenschaften werden Impulse zugeführt, die in der Schaltung, die ein Tiefpaßfilter erster Ordnung darstellt, verändert werden. Aus diesen Veränderungen werden Rückschlüsse auf die Verzögerungszeit gezogen, die Signale erfahren, die die eigentliche, getrennt aufgebaute Signalverarbeitungsschaltung durchlaufen. Die Eigenschaften der eigentlichen Signalverarbeitungsschaltung werden jedoch nicht gemessen.

Es ist Aufgabe der Erfindung, eine Meßschaltung anzugeben, welche eine Ermittlung der Frequenzbandbreite der Signalverarbeitungsschaltung ohne diese Fehler gestattet.

Diese Aufgabe ist erfindungsgemäß dadurch gelöst, daß der Signalverarbeitungsschaltung Meßimpulse zugeführt werden, daß die Meßschaltung in Abhängigkeit der zeitlichen Verschiebung, die die Meßimpulse in der Signalverarbeitungsschaltung erfahren, die Ladung einer in der Meßschaltung vorgesehenen Kapazität verändert, daß die Meßschaltung die Meßkapazität vor jedem Meßvorgang mittels eines elektronischen Schalters kurzzeitig auf ein Bezugspotential schaltet und daß die Meßschaltung auf demselben integrierten Schaltkreis vorgesehen ist wie die Signalverarbeitungsschaltung und nur während eines Meßvorganges aktiviert ist.

Der Erfindung liegt die Erkenntnis zugrunde, daß die Messung der Frequenzbandbreite der Signalverarbeitungsschaltung ohne die oben genannten Fehler am vorteilhaftesten auf dem integrierten Schaltkreis selbst geschehen kann. Daher ist die Meßschaltung zusammen mit dem zu messenden Signalverarbeitungsschaltkreis gemeinsam auf einem integrierten Schaltkreis vorgesehen.

Da es problematisch ist, auf dem integrierten Schaltkreis die Frequenzbandbreite direkt zu messen, wird als Kriterium hierfür die Laufzeit eines Impulses durch die Signalverarbeitungsschaltung herangezogen. Dies kann geschehen, da die Signallaufzeit durch den Schaltkreis ebenso wie die Frequenzbandbreite unmittelbar von dem RC-Produkt des integrierten Schaltkreises abhängig ist. Dieses RC-Produkt wird durch geringfügige Schwankungen in dem Herstellungsprozeß des integrierten Schaltkreises verändert und insbesondere durch parasitäre Kapazitäten, spezifische Kapazitäten des Herstellungsprozesses und differierende Schichtwiderstände erzeugt. Damit kann durch Messung der Signallaufzeit und der damit möglichen Ermittlung des RC-Produktes unmittelbar Rückschluß beispielsweise auch auf die Frequenzbandbreite der Signalverarbeitungsschaltung gezogen werden. Es sind ferner Rückschlüsse auf die Stabilität der Signalverarbeitung in der Signalverarbeitungsschaltung möglich.

Dadurch, daß die Meßschaltung auf dem gleichen integrierten Schaltkreis vorgesehen ist wie die zu messende Signalverarbeitungsschaltung, wird die Meßschaltung von schwankenden Parametern des Herstellungsprozesses in gleicher Weise beeinflußt wie die zu messende Signalverarbeitungsschaltung. Damit ist die Messung der Laufzeit recht genau möglich, da Schwankungen verschiedener Parameter beide Schaltungen in gleicher Weise beeinflussen. Die Anordnung der Meßschaltung auf dem gleichen integrierten Schaltkreis wie die zu messende Signalverarbeitungsschaltung hat insbesondere den Vorteil, das Übergangswiderstände, die von außen anzulegende Kontakte, über die Signale herangeführt oder abgeführt werden, entfallen. Dadurch entfallen wesentliche Fehler bei der Messung.

Die Messung der Signalverarbeitungsschaltung mittels der Meßschaltung wird in der Weise vorgenommen, daß der Signalverarbeitungsschaltung mittels der Meßschaltung Meßimpulse zugeführt werden. Es wird die zeitliche Verschiebung gemessen, die die Meßimpulse nach dem Durchlaufen der Signalverarbeitungsschaltung erfahren haben. In Abhängigkeit dieser gemessenen Zeitdifferenz wird die Ladung einer in der Meßschaltung vorgesehenen Kapazität verändert. Um aus der Ladung der Kapazität Rückschlüsse auf die Zeitverschiebung, die der Impuls durch den Durchlauf durch die Signalverarbeitungsschaltung erfahren hat, ziehen zu können, muß die Meßkapazität vor jedem Meßvorgang mittels eines elektronischen Schalters kurzzeitig auf ein definiertes Bezugspotential geschaltet werden. Dabei muß der Meßvorgang nicht nur im Messen der Durchlaufzeit eines Impulses bestehen; ggf. kann auch eine definierte Zahl von Impulsen in einem Meßvorgang die Schaltung durchlaufen.

In jedem Falle ist nach dem Meßvorgang die Ladung der Kapazität verändert. Diese Veränderung kann ins Verhältnis zur Zahl der eingesetzten Meßimpulse gesetzt werden und ist ein Maß für das RC-Produkt des integrierten Schaltkreises.

Damit ist eine unmittelbare Messung des RC-Produktes und damit, aus diesem leicht ableitbar, der Bandbreite gegeben, ohne daß externe Elemente eingesetzt werden können, die das Meßergebnis verfälschen würden.

Die Meßschaltung ist nur während eines Meßvorganges aktiviert und beeinflußt im übrigen die Signalverarbeitung der Signalverarbeitungsschaltung nicht.

Gemäß einer Ausgestaltung der Erfindung ist vorgesehen, daß der Signalverarbeitungsschaltung für jeden Meßvorgang eine vorgegebene Anzahl von Meßimpulsen zugeführt wird, daß die durch diese erzeugte Veränderung der Ladung der Meßkapazität als Meßgröße dient und daß die Meßschaltung die über der Meßkapazität abfallende Spannung als Meßsignal liefert.

Jeder Meßimpuls führt zu einer Veränderung der Ladung der Meßkapazität, nämlich in Abhängigkeit der Laufzeit, die er durch die Signalverarbeitungsschaltung benötigt hat. Für eine vorgegebene Anzahl von Meßimpulsen wird daher die Ladung der Meßkapazität in einem bestimmten Umfang verändert, der ein Maß für das RC-Produkt des Schaltkreises ist. Diese über der Meßkapazität nach dem Meßvorgang abfallende Spannung liefert die Meßschaltung unmittelbar als Meßsignal nach außen. Diese kann abgegriffen werden und aus ihr können die gewünschten Parameter bestimmt werden.

Alternativ hierzu ist auch eine umgekehrte Vorgehensweise möglich, die, wie gemäß einer weiteren Ausgestaltung der Erfindung vorgesehen ist, darin besteht, daß die Meßschaltung die Anzahl der Impulse zählt, die der Signalverarbeitungsschaltung nach Beginn eines Meßvorgangs zugeführt werden, bis eine vorgegebene Spannung der Meßkapazität erreicht wird und daß die Meßschaltung die gezählte Anzahl Impulse als Meßgröße liefert.

In diesem Falle wird die Veränderung der Ladung der Meßkapazität bzw. eine vorgegebene Spannung, die die Meßkapazität erreichen soll, vorgegeben. Es wird nun die Anzahl der Impulse gezählt, die die Signalverarbeitungsschaltung durchlaufen haben bis die vorgegebene Spannung erreicht ist. Die Abhängigkeit zwischen der Anzahl der Impulse und der Veränderung der Ladung der Meßkapazität und damit der über diese abfallenden Spannung ist hier die gleiche, es wird jedoch der jeweils andere Wert betrachtet. In diesem Fall liefert die Meßschaltung die gezählte Anzahl der Impulse, die die Meßschaltung durchlaufen haben, bis die vorgegebene Spannung an der Meßkapazität erreicht wird. Die Bestimmung der Meßparameter ist anhand dieses Wertes ebenso möglich, da die Abhängigkeiten zwischen Zahl der Meßimpulse und der Veränderung der Spannung der Meßkapazität wie oben gelten.

Für beide Möglichkeiten der Messung ist gemäß einer weiteren Ausgestaltung der Erfindung vorgesehen, daß der Signalverarbeitungsschaltung eine Austastschaltung vorgeschaltet ist, welche in Abhängigkeit der Meßimpulse der Signalverarbeitungsschaltung ein Bezugsschwarzwertsignal oder ein Bezugssignal mit vorgegebener Amplitude, vorzugsweise einer Amplitude entsprechend einem Weißsignalpegel eines Bildsignals, zuführt, wobei die Austastschaltung der Signalverarbeitungsschaltung vorzugsweise während jedes Meßimpulses das Bezugsschwarzwertsignal und während der übrigen Zeiten das Bezugssignal zuführt.

Da die Signalverarbeitungsschaltung dazu vorgesehen ist, ein Bildsignal zu verarbeiten, kann vorteilhafter Weise zur Messung ein einem Bildsignal ähnliches Signal herangezogen werden. Damit wird in Abhängigkeit der Meßimpulse der Signalverarbeitungsschaltung ein Signal zugeführt, welches zwischen einem Bezugsschwarzwertsignal und einem Bezugssignal mit vorgegebener Amplitude, beispielsweise eine Amplitude entsprechend Weißsignalpegel eines Bildsignals, in Abhängigkeit der Meßimpulse hin- und hergeschaltet wird. Dabei kann z.B. während jedes Meßimpulses auf das Bezugssignal entsprechend einem Weißwert und während der übrigen Zeiten, in denen keine Meßimpulse vorliegen, auf das Bezugsschwarzwertsignal geschaltet werden. Bei diesen beiden Signalen handelt es sich um Signale mit deutlich differierenden Pegel, so daß die Flanken in den Umschaltbereichen zwischen den beiden Signalen große Höhe haben und damit gut meßbar sind.

Gemäß einer weiteren Ausgestaltung der Erfindung ist vorgesehen, daß am Ausgang der Signalverarbeitungsschaltung eine Klemmschaltung vorgesehen ist, welche die Gleichspannungslage des die Signalverarbeitungsschaltung durchlaufenden Signals so einstellt, daß während der Zeiten, in denen im Ausgangssignal das, ggf. mittels der Signalverarbeitungsschaltung veränderte, Bezugsschwarzwertsignal auftritt, das Ausgangssignal eine vorgegebene Sollamplitude aufweist.

Gegebenenfalls kann ein wesentlicher Einsatzzweck der Signalverarbeitungsschaltung beispielsweise in einer Verstärkung des Bildsignals oder in einer Veränderung der Helligkeits- und/oder Kontrastwerte des Bildsignals liegen. Damit kann die Amplitude des Signals am Ausgang der Signalverarbeitungsschaltung wesentlich differieren. Hierdurch kann ggf. die Messung der Laufzeit der Meßimpulse bzw. in Abhängigkeit dieser erzeugte Signale beeinflußt werden. Für diese Konstellation ist es daher vorteilhaft, am Ausgang der Signalverarbeitungsschaltung eine Klemmschaltung vorzusehen, welche den Arbeitspunkt der Signalverarbeitungsschaltung so einstellt, daß während der Zeiten, in denen in dem Ausgangssignal das Bezugssschwarzwertsignal auftritt, das Ausgangssignal eine vorgegebene Sollamplitude erreicht. Damit ist für das Ausgangssignal eine definierte Gleichspannungslage gegeben. In den meisten Fällen wird diese Klemmschaltung ohnehin in der Signalverarbeitungsschaltung an deren Ausgang vorgesehen sein, da sie auch für die normalen Einsatzzwecke der Schaltung erforderlich ist. Daher muß diese im Regelfall nicht gesondert für die Meßschaltung vorgesehen werden.

Gemäß einer weiteren Ausgestaltung der Erfindung ist vorgesehen, daß in der Meßschaltung ein erster Detektor, welcher diejenigen Zeitpunkte ermittelt, zu denen während der Vorderflanken oder während der Rückflanken des Eingangssignals der Signalverarbeitungsschaltung ein erstes Bezugspotential erreicht wird, ermittelt, und ein zweiter Detektor vorgesehen sind, welcher diejenigen Zeitpunkte ermittelt, zu denen während der Vorderflanken oder während der Rückflanken des Ausgangssignals der Signalverarbeitungsschaltung ein zweites Bezugspotential erreicht.

Der erste Detektor vergleicht also das Eingangssignal der Signalverarbeitungsschaltung mit einem ersten Bezugspotential. Während der Vorderflanken und während der Rückflanken der Impulse des Eingangssignals wird kurzzeitig ein Potential gleich dem ersten Bezugspotential erreicht. In entsprechender Weise vergleicht ein zweiter Detektor das Ausgangssignal der Signalverarbeitungsschaltung mit einem zweiten Bezugspotential. Auf diese Weise werden sowohl an den Vorderflanken wie auch an den Rückflanken Zeitpunkte ermittelt, zu denen die jeweiligen Bezugspotentiale erreicht werden. Durch Vergleich dieser Zeitpunkte an den Vorder-und/oder an den Rückflanken der Impulse kann die Durchlaufzeit der Impulse durch die Signalverarbeitungsschaltung unmittelbar ermittelt werden.

Wie gemäß einer weiteren Ausgestaltung der Erfindung vorgesehen ist, können die Detektoren vorteilhaft elektronische Schalter ansteuern, mittels derer eine Stromquelle auf die Meßkapazität schaltbar ist. Die elektronischen Schalter sind insbesondere deshalb vorteilhaft, weil sie nahezu verzögerungsfrei schalten können. Mittels der Stromquelle wird die Ladung der Meßkapazität in gewünschter Weise verändert.

Nachfolgend wird anhand der Zeichnung ein Ausführungsbeispiel der Erfindung näher erläutert. Es zeigen:
Fig. 1 ein Blockschaltbild einer erfindungsgemäßen Meßschaltung zusammen mit einer angedeuteten S ignalverarbeitungsschaltung,
Fig. 2 Zeitdiagramme und zur Messung eingesetzten Signalen und
Fig. 3 Zeitdiagramme dieser Signale zur Erläuterung der Arbeitsweise der Meßschaltung.

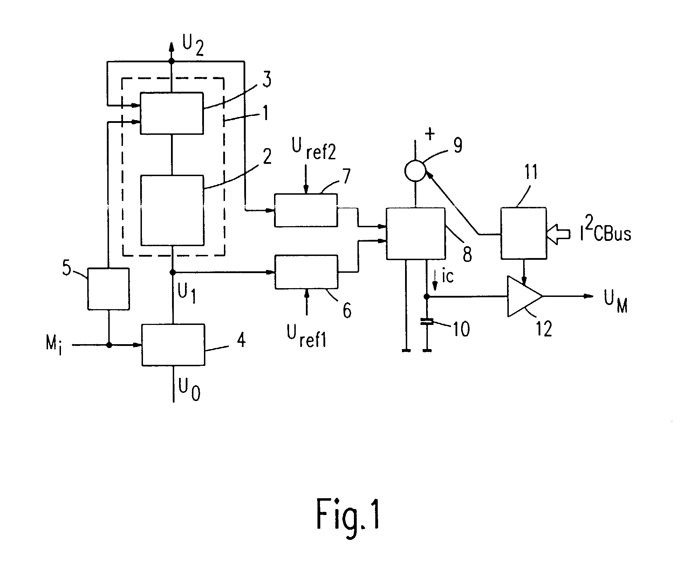

In dem Blockschaltbild in Fig. 1 ist eine Signalverarbeitungsschaltung 1 angedeutet. Diese ist in der Figur nicht näher ausgeführt. Es sind lediglich die eigentliche Schaltung 2 zur Verarbeitung des Signals und eine Ausgangsklemmschaltung 3 symbolisiert. Bei der Signalverarbeitungsschaltung 1 kann es sich beispielsweise um eine Schaltungsanordnung zur Verstärkung eines Bildsignals, zur Regelung von Helligkeit und/oder Kontrast oder Ähnlichem handeln.

Alle übrigen in der Fig. 1 dargestellten Elemente gehören zu der erfindungsgemäßen Meßschaltung, die gemeinsam mit der Signalverarbeitungsschaltung 1 auf einem integrierten Schaltkreis, d.h. einem Substrat vorgesehen ist.

Der Meßschaltung wird extern ein Signal Mᵢ zugeführt, welches Meßimpulse aufweist. Das Signal Mᵢ wird einer Austast- und Klemmschaltung 4 sowie einem Schaltungsblock 5 zur Steuerung der Klemmschaltung 3 der Signalverarbeitungsschaltung 1 zugeführt.

Ein ggf. durch die Signalverarbeitungsschaltung 1 zu verarbeitendes Signal U₀ gelangt über die Austast- un Klemmschaltung 4 als Signal U₁ an die Signalverarbeitungsschaltung 1. Innerhalb der Signalverarbeitungsschaltung 1 durchläuft dieses Signal zunächst die eigentliche Signalverarbeitung 2 und nachfolgend die Ausgangsklemmschaltung 3. Das Ausgangssignal der Ausgangsklemmschaltung 3, welches in der Figur mit U₂ bezeichnet ist, wird auf die Ausgangsklemmschaltung 3 rückgekoppelt.

In der Meßschaltung sind ferner zwei Detektoren 6 und 7 vorgesehen.

Der erste Detektor 6 vergleicht das Eingangssignal U₁ der Signalverarbeitungsschaltung 1 mit einem Bezugspotential U_{ref1}. In entsprechender Weise vergleicht der zweite Detektor 7 das Ausgangssignal U₂ der Signalverarbeitungsschaltung 1 mit einem Bezugspotential U_{ref2}.

Beide Detektoren steuern in einem Schaltungsblock 8 vorgesehene und in der Figur nicht näher angedeutete elektronische Schalter an. In Abhängigkeit dieser Schaltzeiten der elektronischen Schalter wird ein von einer Stromquelle 9 gelieferter Strom auf eine Meßkapazität 10 geschaltet. Dieser Strom kann ggf. während der übrigen Zeiten auf Masse abgeleitet werden.

Innerhalb der Meßschaltung ist ferner eine Steuerschaltung 11 vorgesehen, welche die Stromquelle 9 und einen Impedanzwandler 12 sowie ggf. die Erzeugung des Meßsignals Mᵢ steuert. Diese Steuerung wiederum kann in Abhängigkeit eines Steuersignals, das beispielsweise von einem I²C-Bus stammen kann, vorgenommen werden.

Während eines Meßvorganges wird mittels des von der Stromquelle 9 kommenden Stromes I_{C} die Ladung der Meßkapazität 10 verändert. Die an der Meßkapazität 10 abfallende Spannung wird mittels des Impedanzwandlers 12 verstärkt und ausgangsseitig als Meßsignal U_{M} zur Verfügung gestellt.

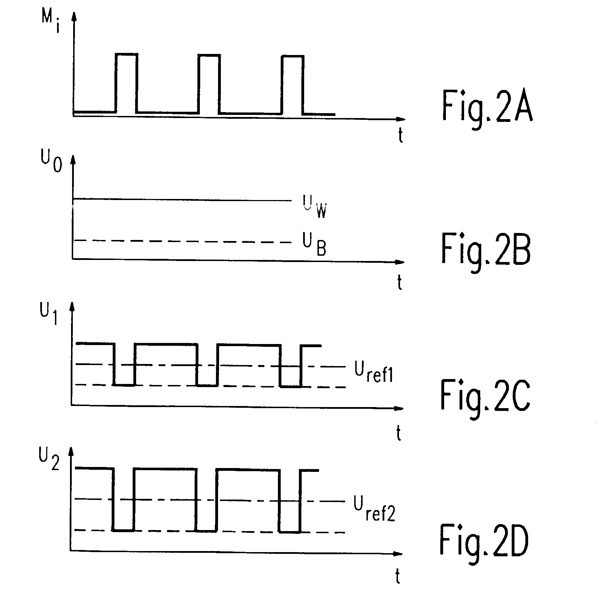

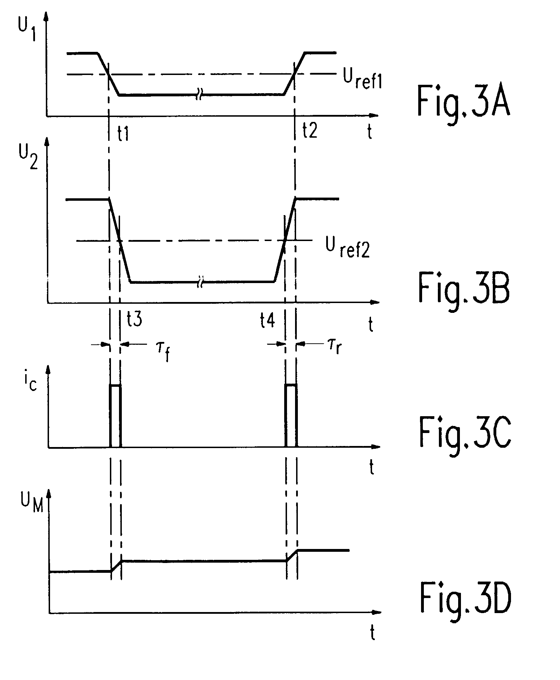

Die Arbeitsweise dieser in der Fig. 1 dargestellten Meßschaltung wird nachfolgend anhand der Fig. 2 und 3 näher erläutert.

In Fig. 2a) ist das Meßsignal Mᵢ mit Meßimpulsen über der Zeit dargestellt. Es besteht einerseits die Möglichkeit, die Meßimpulse des Meßsignales Mᵢ direkt der Signalverarbeitungsschaltung 1 gemäß Fig. 1 zur Messung von deren zeitlicher Verzögerung zuzuführen. Darüber hinaus besteht jedoch vorteilhaft auch die Möglichkeit, Impulse in Abhängigkeit dieser Meßimpulse zu erzeugen.

Dazu werden der Austast- und Klemmschaltung 4 der Schaltungsanordnung gemäß Fig. 1 zwei Signale U_{W} und U_{B}, die Bestandteile des Signals U₀ sind, zugeführt. Wie die Darstellung gemäß Fig. 2b) zeigt, handelt es sich bei diesem Signal U_{B} um ein Bezugsschwarzwertsignal. Dieses Bezugsschwarzwertsignal weist eine Amplitude entsprechend der Schwarzschulter des konventionellen Bildsignals auf. Das Bezugssignal U_{W} weist eine Amplitude entsprechend einem maximalen Weißwert eines Bildsignals auf.

Wie die Darstellung gemäß Fig. 2c) zeigt, wird mittels der Austast- und Klemmschaltung 4 entsprechend Fig. 1 ein Eingangssignal U₁ für die Signalverarbeitungsschaltung 1 erzeugt, welches während in dem Meßsignal Mᵢ gemäß Fig. 2a) auftretender Impulse eine Amplitude entsprechend dem Bezugsschwarzwertsignal U_{B} entsprechend der Darstellung gemäß Fig. 2b) aufweist. Während der übrigen Zeiten ist dieses Signal U₁ entsprechend gemäß Fig. 2c) auf eine Amplitude entsprechend des Bezugssignals U_{W} der Darstellung gemäß Fig. 2b) geschaltet. Damit weist das der Signalverarbeitungsschaltung 1 gemäß Fig. 1 zugeführte Signal U₁ Meßimpulse auf, die zeitgleich mit den Impulsen des Meßsignals Mᵢ auftreten.

Die Darstellung gemäß Fig. 2d) zeigt das Ausgangssignal U₂ der Signalverarbeitungsschaltung 1 gemäß Fig. 1. Der zeitliche Verlauf dieses Signals U₂ gemäß Fig. 2d) zeigt, daß grundsätzlich die Meßimpulse am Ausgangssignal wieder auftreten. Sie haben infolge der Verstärkung in der Signalverarbeitungsschaltung eine andere Amplitude und weisen eine geringfügige Verzögerung gegenüber den Impulsen im Signal U₁ auf. Diese zeitliche Verzögerung, die die Impulse durch den Durchlauf durch die Signalverarbeitungsschaltung erfahren haben, wird zur Messung herangezogen.

Das Signal gemäß Fig. 2d) wird in der Ausgangsklemmschaltung 3 der Signalverarbeitungsschaltung gemäß Fig. 1 in der Weise geklemmt, daß das Signal während der Impulse, d.h. während der Zeiten, während der es eingangsseitig auf Bezugsschwarzwertsignal geklemmt wurde, ebenfalls eine Amplitude entsprechend dem Bezugsschwarzwertsignal aufweist. Infolge der Verstärkung, die das Signal in der Signalverarbeitungsschaltung erhalten hat, weist es während der übrigen Zeiten eine größere Weißamplitude als das Eingangssignal auf.

Das Zeitdiagramm gemäß Fig. 3a) zeigt, in zeitlich gestreckter Form, einen Impuls des Eingangssignals U₁ entsprechend der Darstellung gemäß Fig. 2c). Ein solcher Impuls wird mittels des ersten Detektors 6 der Schaltungsanordnung gemäß Fig. 1 mit dem Bezugspotential U_{ref1} verglichen. Es werden diejenigen Zeitpunkte t₁ und t₂ ermittelt, zu denen die Vorderflanke bzw. die Rückflanke des in Fig. 3a) zeitlich gestreckt dargestellten Impulses jeweils genau den Spannungswert des Bezugspotentials U_{ref1} aufweist.

In entsprechender Weise wird entsprechend der Darstellung gemäß Fig. 3b) das die Signalverarbeitungsschaltung gemäß Fig. 1 verlassende Signal U₂ mittels des zweiten Detektors 7 gemäß Fig. 1 mit einem zweiten Bezugspotential U_{ref2} verglichen. Auch hier werden diejenigen Zeitpunkte ermittelt, in denen das Signal während der Vorder- bzw. Rückflanke genau den Spannungswert entsprechend dem Bezugspotential U_{ref2} aufweist. In dem Beispiel gemäß Fig. 3b) ist dies zu den Zeitpunkten t₃ und t₄ der Fall.

In der Schaltungsanordnung gemäß Fig. 1 liefern die Detektoren 6 und 7 zu den Zeitpunkten t₁ bis t₄ entsprechende Impulse an den Schaltungsblock 8 mit den elektronischen Schaltern. In Abhängigkeit dieser Impulse der Detektoren wird während der Zeitspanne t₁ bis t₃, die in der Darstellung gemäß Fig. 3c) mit τ_{f} gekennzeichnet ist, ein elektronischer Schalter geschlossen, so daß entsprechend der Darstellung gemäß Fig. 1 der Ladestrom I_{c}, der von der Stromquelle 9 stammt, auf die Meßkapazität 10 geführt wird. Entsprechend der Darstellung gemäß Fig. 3c) ist dieses mit einem Impuls der über der Zeit dargestellten Stromkurve I_{c} angedeutet.

Während der Rückflanke des in Fig. 3 zeitlich gestreckt dargestellten Impulses, nämlich zwischen dem Zeitpunkt t₂, zu dem das Eingangssignal U₁ das Bezugspotential U_{ref1} erreicht, und dem Zeitpunkt t₄, zu dem das Ausgangssignal das Bezugspotential U_{ref2} erreicht, wird in entsprechender Weise ein Impuls des Signals I_{c} erzeugt, in dem während der Zeitspanne t₂ bis t₄ ein elektronischer Schalter geschlossen wird und einen Impuls dieses Stromes auf die Meßkapazität schaltet. Die Zeitdifferenz t₂ bis tₜ ist in der Darstellung gemäß Fig. 3c) mit τᵣ, gekennzeichnet.

Mit jedem Impuls des Signales I_{c} wird die Ladung der Meßkapazität 10 der Schaltung gemäß Fig. 1 verändert. Dies zeigt die Darstellung gemäß Fig. 3d). In dieser Darstellung ist die Ausgangsspannung U_{M} dargestellt. Dieses Meßsignal wird mittels des Impedanzwandlers 12 der Darstellung gemäß Fig. 1 in Abhängigkeit der über der Meßkapazität 10 abfallenden Spannung erzeugt. Diese in Fig. 3d) über der Zeit aufgetragene Meßspannung U_{M} zeigt, daß mit jedem Impuls des Signales I_{c} gemäß Fig. 3c) die Ladung der Meßkapazität und damit der Spannungswert des Meßsignals U_{M} verändert wird. In diesem Falle wird die Ladung der Meßkapazität mit jedem Impuls des Signales I_{c} erhöht.

Aus dieser Veränderung der Ladung der Meßkapazität und damit der Veränderung des Meßsignals U_{M} kann in Abhängigkeit der eingesetzten Zahl der Impulse Rückschlüsse auf die Bandbreite der Signalverarbeitungsschaltung gezogen werden. Dies ist deshalb möglich, da sowohl die Bandbreite der Signalverarbeitungsschaltung wie auch die entsprechend Fig. 3 gemessene zeitliche Verzögerung eines Impulses durch die Signalverarbeitungsschaltung abhängig sind von den physikalischen Eigenschaften der integrierten Schaltung, insbesondere des RC-Produktes, das diese erzeugt.

Damit gestattet die Meßschaltung gemäß Fig. 1 auf relativ einfache und zugleich sichere Weise eine Messung der Frequenzbandbreite der Signalverarbeitungsschaltung 1. bie in der Fig. 1 dargestellten Elemente sind mit dieser gemeinsam auf einem Substrat eines integrierten Schaltkreises vorgesehen und werden damit von Herstellungstoleranzen des Substrates in gleicher Weise betroffen wie die Signalverarbeitungsschaltung 1. Die Meßschaltung ist nur während der Meßzeiten aktiviert. Während der übrigen Zeiten wird ein Eingangssignal U₀, bei dem es sich beispielsweise um ein Bildsignal handelt, in durch die Meßschaltung unveränderter Weise durch die Signalverarbeitungsschaltung 1 geführt.

Vor und nach jedem Meßvorgang bzw. ggf. während aller Zeiten, in denen keine Messung stattfindet, wird die Meßkapazität 10 der Darstellung gemäß Fig. 1 auf ein definiertes Bezugspotential geladen. Dies kann ggf. ebenfalls mittels des Schaltungsblockes 8 geschehen.

## Patentansprüche

1. Meßschaltung für eine auf einem integrierten Schaltkreis vorgesehene Signalverarbeitungsschaltung (1) zur Verarbeitung wenigstens eines Bildsignals, dadurch gekennzeichnet,
daß der Signalverarbeitungsschaltung (1) Meßimpulse zugeführt werden, daß die Meßschaltung in Abhängigkeit der zeitlichen Verschiebung, die die Meßimpulse in der Signalverarbeitungsschaltung (1) erfahren, die Ladung einer in der Meßschaltung vorgesehenen Kapazität (10) verändert, daß die Meßschaltung die Meßkapazität (10) vor jedem Meßvorgang mittels eines elektronischen Schalters (8) kurzzeitig auf ein Bezugspotential schaltet und daß die Meßschaltung auf demselben integrierten Schaltkreis vorgesehen ist wie die Signalverarbeitungsschaltung (1) und nur während eines Meßvorganges aktiviert ist.

2. Meßschaltung nach Anspruch 1, dadurch gekennzeichnet,
daß der Signalverarbeitungsschaltung (1) für jeden Meßvorgang eine vorgegebene Anzahl von Meßimpulsen zugeführt wird, daß die durch diese erzeugte Veränderung der Ladung der Meßkapazität (10) als Meßgröße dient und daß die Meßschaltung die über der Meßkapazität (10) abfallende Spannung als Meßsignal liefert.

3. Meßschaltung nach Anspruch 1, dadurch gekennzeichnet,
daß die Meßschaltung die Anzahl der Impulse zählt, die der Signalverarbeitungsschaltung (1) nach Beginn eines Meßvorgangs zugeführt werden, bis eine vorgegebene Spannung der Meßkapazität (10) erreicht wird und daß die Meßschaltung die gezählte Anzahl Impulse als Meßgröße liefert.

4. Meßschaltung nach einem der Ansprüche 1 bis 3, dadurch gekennzeichnet,
daß der Signalverarbeitungsschaltung (1) eine Austastschaltung (4) vorgeschaltet ist, welche in Abhängigkeit der Meßimpulse der Signalverarbeitungschaltung (1) ein Bezugsschwarzwertsignal oder ein Bezugssignal mit vorgegebener Amplitude, vorzugsweise einer Amplitude entsprechend einem Weißsignalpegel eines Bildsignals, zuführt, wobei die Austastschaltung (4) der Signalverarbeitungsschaltung vorzugsweise während jedes Meßimpulses das Bezugsschwarzwertsignal und während der übrigen Zeiten das Bezugssignal zuführt.

5. Meßschaltung nach Anspruch 4, dadurch gekennzeichnet,
daß am Ausgang der Signalverarbeitungsschaltung eine Klemmschaltung (3) vorgesehen ist, welche die Gleichspannungslage des die Signalverarbeitungsschaltung (1) durchlaufenden Signals so einstellt, daß während der Zeiten, in denen im Ausgangssignal das, ggf. mittels der Signalverarbeitungsschaltung veränderte, Bezugsschwarzwertsignal auftritt, das Ausgangssignal eine vorgegebene Sollamplitude aufweist.

6. Meßschaltung nach einem der Ansprüche 1 bis 5, dadurch gekennzeichnet,
daß in der Meßschaltung ein erster Detektor (6), welcher diejenigen Zeitpunkte ermittelt, zu denen während der Vorderflanken oder während der Rückflanken des Eingangssignals der Signalverarbeitungsschaltung ein erstes Bezugspotential erreicht wird, ermittelt, und ein zweiter Detektor (7) vorgesehen sind, welcher diejenigen Zeitpunkte ermittelt, zu denen während der Vorderflanken oder während der Rückflanken des Ausgangssignals der Signalverarbeitungsschaltung ein zweites Bezugspotential erreicht.

7. Meßschaltung nach Anspruch 6, dadurch gekennzeichnet,
daß die Detektoren (6, 7) elektronische Schalter ansteuern, mittels derer eine Stromquelle auf die Meßkapazität (10) schaltbar ist.

8. Meßschaltung nach einem der Ansprüche 1, 2 oder 4 bis 7, dadurch gekennzeichnet,
daß ein Impedanzwandler (12) vorgesehen ist, der eingangsseitig mit der Meßkapazität (10) gekoppelt ist und der ausgangsseitig das Meßsignal liefert.

9. Bildwiedergabegerätt mit einem integrierten Schaltkreis, welcher eine Signalverarbeitungschaltung und eine Meßschaltung nach einem der Ansprüche 1 bis 8 aufweist.
